# EUROPEAN PATENT SPECIFICATION

(11) **EP 4 503 139 B1**
(45) Date of publication and mention of the grant of the patent: **01.07.2026**
(21) Application number: 23774695.3
(22) Date of filing: 15.03.2023
(51) Int. Cl.: H10D 12/00, H10D 30/01, H10D 30/43, H10D 30/63, H10D 62/13, H10D 62/10, H10D 62/85, H10D 12/01, B82Y 10/00

(54) **FIELD EFFECT TRANSISTOR AND SWITCH ELEMENT**
FELDEFFEKTTRANSISTOR UND SCHALTELEMENT
TRANSISTOR À EFFET DE CHAMP ET ÉLÉMENT DE COMMUTATION

(30) Priority: 24.03.2022 JP 2022048567
(43) Date of publication of application: 05.02.2025
(73) Proprietor: National University Corporation Hokkaido University, Hokkaido 060-0808 (JP)
(72) Inventor: TOMIOKA, Katsuhiro, Sapporo-shi, Hokkaido 060-0808 (JP); GAMO, Hironori, Sapporo-shi, Hokkaido 060-0808 (JP)
(74) Representative: Bjerkén Hynell KB
(86) International application number: PCT/JP2023/010069
(87) International publication number: WO 2023/182099

(56) References cited:
- WO-A1-2016/119682
- WO-A1-2017/057329
- WO-A1-2020/138168
- JP-A- 2013 110 160
- JP-A- 2013 187 291
- US-A1- 2014 353 593
- US-A1- 2014 353 593
- US-A1- 2020 411 700
- KATSUHIRO TOMIOKA ET AL: "Recent progress in integration of III-V nanowire transistors on Si substrate by selective-area gr", JOURNAL OF PHYSICS D: APPLIED PHYSICS, INSTITUTE OF PHYSICS PUBLISHING, BRISTOL, GB, vol. 47, no. 39, 11 September 2014 (2014-09-11), pages 394001, XP020270880, ISSN: 0022-3727, [retrieved on 20140911], DOI: 10.1088/0022-3727/47/39/394001

## Description

### Technical Field

The present invention relates to a field-effect transistor and a switching element.

### Background Art

A semiconductor microprocessor and the highly integrated circuit are manufactured by integrating, on a semiconductor substrate, elements such as a metal-oxide-semiconductor (also referred to as "MOS") field-effect transistor (also referred to as "FET"). Generally, a complementary MOSFET (hereinafter, also referred to as "CMOS") serves as a basic element (switching element) of an integrated circuit. Silicon, which is a Group IV semiconductor, is mainly used as the material for the semiconductor substrate. By reducing the size of the transistors constituting a CMOS, it is possible to improve the degree of integration and the performance of semiconductor microprocessors and high-density circuits. One of the challenges in reducing the size of a CMOS is an increase in power consumption. The two main causes of the increase in power consumption include an increase in the number of CMOSs mountable on one microchip and an increase in the leak current due to the short-channel effect.

A tunnel FET (hereinafter referred to as "TFET") is known as a switching element that operates with a subthreshold coefficient smaller than that of a general MOSFET. As the TFET does not have a short-channel effect and can achieve a high ON/OFF ratio at a low voltage, the TFET is considered a promising candidate for a next-generation switching element. Recently, a TFET using a Group III-V compound semiconductor nanowire has been reported (see, for example, PTL 1).

PTL2 discloses a nanowire TFET wherein a III-V based nanowire comprising a core and a shell is directly provided on a silicon substrate. The silicon substrate together with the core do form a first terminal of the TFET, and the shell does form a second terminal of the TFET. Each terminal is connected to a respective electrode. PTL2 does not disclose that a conductivity type of the shell is the same as that of the substrate. Similarly, PTL2 does not disclose that a conductivity type of the core is opposite to that of the substrate.

PTL3 and NPL1 disclose a vertical nanowire TFET. According to PTL3 and NPL1, a shell structure is provided, the shell structure comprises a HEMT. All elements forming part of the HEMT structure have the same conductivity type as the core. An upper electrode is connected to the core and the shell.

PTL4 discloses a vertical nanowire TFET. According to PTL4, a shell structure is provided. An upper electrode is connected to the core.

PTL5 discloses a vertical nanowire semiconductor device. According to PTL5, a shell structure is provided. An upper electrode is connected to the core.

### Citation List

### Patent Literature

PTL 1
   WO2011/040012
PTL 2
   US 2014/353593 A1
PTL 3
   WO 2017/057329 A1
PTL 4
   WO 2016/119682 A1
PTL 5
   US 2020/411700 A1

### Non Patent Literature

NPL 1
Katsuhiro Tomioka and Takashi Fukui, "Recent progress in integration of III-V nanowire transistors on Si substrate by selective-area growth", Journal of Physics D: Applied Physics, Vol. 47, No. 39, 11 Page 394001

### Summary of Invention

### Technical Problem

In a conventional FET, it is necessary to manufacture elements with different structures in order to achieve different switching characteristics. For example, in a CMOS configured by Si-MOSFETs, it was necessary to separately manufacture an n-p-n structure and a p-n-p structure.

An object of the present invention is to provide a field-effect transistor that exhibits a plurality of switching characteristics with a single element structure and provide a switching element including the field-effect transistor.

### Solution to Problem

A field-effect transistor according to the present invention is defined in claim 1.

The switching element according to the present invention includes the above-described field-effect transistor.

### Advantageous Effects of Invention

The present invention can provide a field-effect transistor that exhibits a plurality of switching characteristics with a single element structure and provide a switching element including the field-effect transistor.

### Brief Description of Drawings

FIG. 1 is a cross-sectional schematic view illustrating the configuration of an FET according to Embodiment 1 of the present invention;
FIGS. 2A to 2C illustrate how the FET according to Embodiment 1 operates as an nTFET;
FIGS. 3A to 3C illustrate how the FET according to Embodiment 1 operates as a pFET;
FIG. 4 is a cross-sectional schematic view illustrating the configuration of an FET according to Embodiment 2 of the present invention;
FIG. 5 is a scanning electron microscope photograph of a silicon substrate with periodically arranged core-shell nanowires;
FIG. 6A is a graph illustrating the relationship between the gate voltage and the drain current when the TFET in an example operates as an nTFET, and FIG. 6B is a graph illustrating the relationship between the drain voltage and the drain current when the TFET of the example operates as an nTFET; and
FIG. 7A is a graph illustrating the relationship between the gate voltage and the drain current when the TFET in the example operates as a pFET, and FIG. 7B is a graph illustrating the relationship between the drain voltage and the drain current when the TFET of the example operates as a pFET.

### Description of Embodiments

Hereinafter, an embodiment of the present invention will be described in detail with reference to the drawings.

### [Embodiment 1]

### (Configuration of Field-Effect Transistor)

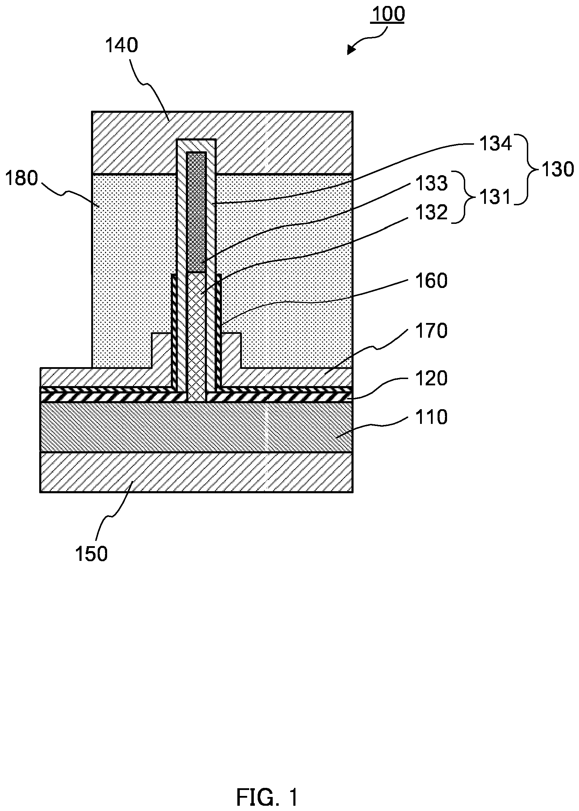

FIG. 1 is a cross-sectional schematic view illustrating the configuration of field-effect transistor (FET) 100 according to Embodiment 1 of the present invention. As illustrated in FIG. 1, FET 100 according to the present embodiment includes substrate 110, insulating film 120, core-shell nanowire 130, first electrode 140, second electrode 150, gate dielectric film 160, gate electrode 170, and insulating protective film 180. Hereinafter, each configuration will be described.

Substrate 110 is made of a Group IV semiconductor such as silicon or germanium, and includes a (111) surface. Substrate 110 is doped to a first conductivity type (n-type or p-type). For example, the substrate is an n-type silicon (111) substrate or a p-type silicon (111) substrate.

Insulating film 120 covers the (111) surface of substrate 110 and has one or more openings. Insulating film 120 functions as a mask pattern when growing core nanowire 131 from the (111) surface of substrate 110. Any material may be used for insulating film 120 as long as the material can inhibit the growth of a core nanowire and is an insulator. Examples of the material of insulating film 120 include silicon oxide (SiO₂), silicon nitride (SiN), and aluminum oxide (Al₂O₃). Insulating film 120 may be a single layer or may be composed of two or more layers. The film thickness of the insulating film 120 is not particularly limited as long as the film thickness can appropriately exhibit the insulation performance. For example, insulating film 120 is a silicon oxide film having a thickness of 10 to 100 nm.

An opening in insulating film 120 extends to the (111) surface of substrate 110, and the (111) surface of substrate 110 is exposed in the opening. The opening, when manufacturing FET 100, defines the growth position, thickness, and shape of core nanowire 131. The shape of the opening is not particularly limited and can be determined in any shape. Examples of the shape of the opening include a triangle, a quadrangle, a hexagon, and a circle. The diameter of the circumscribed circle of the opening may be approximately 2 to 500 nm. When the number of the openings is two or more, the center-to-center distance between the openings may be several tens of nm to several µm.

Core-shell nanowire 130 is a structure made of a Group III-V compound semiconductor, with a diameter of approximately 7.6 nm to 1 µm and a length of approximately 100 nm to 100 µm. Core-shell nanowire 130 is disposed on the (111) surface of substrate 110 exposed in the opening of insulating film 120 and on insulating film 120 around the (111) surface, such that the long axis of core-shell nanowire 130 is perpendicular to the (111) surface of substrate 110. According to the invention, core nanowire 131 of core-shell nanowire 130 is disposed on the (111) surface of substrate 110 exposed in the opening of insulating film 120, and shell layer 134 covering the surface of core nanowire 131 is disposed on insulating film 120 around the opening. As described above, by forming core nanowire 131 on the (111) surface of substrate 110, it is possible to dispose core nanowire 131 so as to be perpendicular to the (111) surface.

As illustrated in FIG. 1, core-shell nanowire 130 includes core nanowire 131 and shell layer 134 that covers the surface of core nanowire 131. Shell layer 134 covers the side surface of core nanowire 131 and the end surface of core nanowire 131 on the first electrode 140 side, but does not cover the end surface of core nanowire 131 on the substrate 110 side. Here, the "side surface of core nanowire 131" means a surface along the central axis (long axis) of core nanowire 131, and the "end surface of core nanowire 131" means a surface intersecting with the central axis of core nanowire 131.

Core nanowire 131 is made of a Group III-V compound semiconductor doped to a second conductivity type (p-type or n-type) different from the conductivity type (first conductivity type) of substrate 110, and extends upward from the (111) surface of substrate 110 through the opening of insulating film 120. The Group III-V compound semiconductor constituting core nanowire 131 may be a binary compound semiconductor, a ternary compound semiconductor, a quaternary compound semiconductor, or a semiconductor made of more than four elements. Examples of the binary compound semiconductor include InAs, InP, GaAs, GaN, InSb, GaSb, and AlSb. Examples of the ternary compound semiconductors include AlGaAs, InGaAs, InGaN, AlGaN, GaNAs, InAsSb, GaAsSb, InGaSb, and AlInSb. Examples of the quaternary compound semiconductor include InGaAlN, AlInGaP, InGaAsP, GaInAsN, InGaAlSb, InGaAsSb, and AlInGaPSb. The thickness (diameter of the circumscribed circle of a cross section orthogonal to the axial direction) of core nanowire 131 may be approximately 2 to 500 nm. Further, the length of core nanowire 131 may be approximately 100 nm to 100 µm. For example, core nanowire 131 is an 80 nm-thick In_{0.7}Ga_{0.3}As nanowire.

Core nanowire 131 may be divided into first region 132 connected to the (111) surface of substrate 110 and second region 133 not connected to the (111) surface, but does not have to be divided. In the present embodiment, core nanowire 131 includes first region 132 and second region 133. Both first region 132 and second region 133 are doped to the second conductivity type (p-type or n-type), but the impurity density of first region 132 is different from the impurity density of second region 133. For example, when substrate 110 is a p-type silicon (111) substrate, first region 132 is made of an InGaAs nanowire low-doped to n-type, and second region 133 is made of an InGaAs nanowire high-doped to n-type. Further, when substrate 110 is an n-type silicon (111) substrate, first region 132 is made of an InGaAs nanowire low-doped to p-type, and second region 133 is made of an InGaAs nanowire high-doped to p-type. The impurity density in first region 132 is not particularly limited as long as first region 132 has the second conductivity type, and is, for example, within a range of 10¹⁵ to 10²⁰ cm⁻³. The impurity density in second region 133 is not particularly limited as long as second region 133 has the second conductivity type, and is, for example, within a range of 10¹⁶ to 10²⁰ cm⁻³. The impurity density of core nanowire 131 when core nanowire 131 is not divided into first region 132 and second region 133 is not particularly limited as long as core nanowire 131 is a second conductivity type, and is, for example, in the range of 10¹⁵ to 10²⁰ cm⁻³. Second region 133 is electrically connected to first electrode 140 via shell layer 134. First region 132 of core nanowire 131 and the (111) surface of substrate 110 form a bonding interface that is basically dislocation-free and defect-free.

In FET 100 according to the present embodiment, the bonding interface between the (111) surface of substrate 110 made of a Group IV semiconductor and core nanowire 131 made of a Group III-V compound semiconductor is preferably dislocation-free and defect-free, but may include a small number of dislocations or defects. Specifically, the period of the misfit dislocation at the bonding interface is larger than the period of the misfit dislocation calculated from the lattice mismatch between the Group IV semiconductor constituting substrate 110 and the Group III-V compound semiconductor constituting core nanowire 131. Further, the density of the through-thickness dislocation at the bonding interface is within a range of 0 to 10¹⁰ pieces/cm². By forming the core nanowire 131 using the manufacturing method described below, it is possible to manufacture the FET 100 of the present embodiment, which has a bonding interface with basically no dislocations and no defects. The manufacturing method is not claimed but it is useful for understanding the present invention.

Shell layer 134 covers the surface of core nanowire 131. Shell layer 134 is in contact with insulating film 120, but is not in contact with substrate 110. Shell layer 134 is made of a Group III-V compound semiconductor doped to a first conductivity type (n-type or p-type) different from the second conductivity type of core nanowire 131. The Group III-V compound semiconductor constituting shell layer 134 is not particularly limited as long as these conditions are satisfied. The Group III-V compound semiconductor that constitutes shell layer 134 is the same as the Group III-V compound semiconductor described as an example of core nanowire 131 described above. The impurity density of shell layer 134 is not particularly limited as long as shell layer 134 is of the first conductivity type, and is, for example, in a range of 10¹⁵ to 10²⁰ cm⁻³. The film thickness of shell layer 134 is not particularly limited and may be, for example, approximately 1 to 200 nm. From the viewpoint of increasing the drain current when FET 100 operates as the FET of the first conductivity type, it is preferable that the film thickness of shell layer 134 is large. On the other hand, from the viewpoint of increasing the effective gate electric field strength when FET 100 operates as a TFET of the second conductivity type, it is preferable that the film thickness of shell layer 134 be small. For example, when core nanowire 131 is an n-type doped InGaAs nanowire, shell layer 134 is a highly p-type doped GaSb layer with a film thickness of 45 nm.

First electrode 140 is electrically connected to core-shell nanowire 130. According to the invention, first electrode 140 is electrically connected to shell layer 134 of core-shell nanowire 130. Second electrode 150 is electrically connected to substrate 110. First electrode 140 functions as one of the source electrode and the drain electrode, and second electrode 150 functions as the other one of the source electrode and the drain electrode. For example, first electrode 140 may function as a drain electrode, and second electrode 150 may function as a source electrode. In this case, second electrode 150 may be grounded. Further, first electrode 140 may function as a source electrode, and second electrode 150 may function as a drain electrode. In this case, first electrode 140 may be grounded.

The type of first electrode 140 is not particularly limited, but a metal film, an alloy film, or a metal multilayer film each capable of making ohmic contact with shell layer 134 is preferable. An example of the metal film capable of making ohmic contact with shell layer 134 is Mo. Examples of the metal multilayer film capable of making ohmic contact with shell layer 134 include Ti/Au multilayer films, Ni/Ge/Au multilayer films, Ge/Au/Ni/Au multilayer films, Ti/Pt/Au multilayer films, and Ti/Pd/Au multilayer films. The type of second electrode 150 is not particularly limited, but is preferably a metal film, an alloy film, a metal multilayer film, or a silicide metal film each capable of making ohmic contact with substrate 110. Examples of the metal multilayer film capable of making ohmic contact with substrate 110 include Ti/Au multilayer films and Ni/Au multilayer films. Examples of the silicide metal film capable of making ohmic contact with substrate 110 include NiSi films and TiSi films. In the present embodiment, first electrode 140 is a Ti/Au multilayer film or a Ge/Au/Ni/Au multilayer film disposed on core-shell nanowire 130 and insulating protective film 180, and second electrode 150 is a Ti/Au multilayer film formed on substrate 110.

Gate dielectric film 160 covers at least a part of the side surface of core-shell nanowire 130. In the present embodiment, gate dielectric film 160 covers a part of the side surface of core-shell nanowire 130 (the part on the substrate 110 side), and also covers insulating film 120. The material of gate dielectric film 160 is not particularly limited, but is preferably a high dielectric. Examples of the material of gate dielectric film 160 include hafnium aluminate (HfAlOₓ), zirconium oxide (ZrO₂), and lanthanum oxide (La₂O₃). For example, gate dielectric film 160 is a hafnium aluminate film having a film thickness of 10 nm.

Gate electrode 170 is disposed on gate dielectric film 160 so as to cover at least a part of the periphery of core-shell nanowire 130. More specifically, gate electrode 170 is disposed on gate dielectric film 160 such that an electric field is applied to a bonding interface between substrate 110 and core nanowire 131, and to a portion of shell layer 134 (the portion immediately below gate electrode 170). In the present embodiment, gate electrode 170 is disposed so as to surround the end of core-shell nanowire 130 (the end on the substrate 110 side). That is, FET 100 according to the present embodiment is a gate-all-around (GAA) FET.

The type of gate electrode 170 is not particularly limited as long as gate electrode 170 has conductivity, and is, for example, a metal film, a metal multilayer film, a metal compound film, or another conductive film. Examples of metals constituting the metal film include W, Ti, Pt, Au, and Mo. Examples of the metal multilayer film include Ti/Au multilayer films. Examples of the metal compound film include tantalum nitride (TaN) films and tungsten nitride (WN) films. In the present embodiment, gate electrode 170 is a Ti/Au multilayer film formed on gate dielectric film 160.

Insulating protective film 180 is a film made of insulating resin and covers core-shell nanowire 130, gate dielectric film 160, and gate electrode 170. The type of insulation resin is not particularly limited, but, for example, is a BCB resin.

### (Operation of Field-Effect Transistor)

When the polarity of the gate voltage is one of positive and negative, FET 100 according to the present embodiment operates as a second conductivity type tunneling field-effect transistor (TFET) in which gate electrode 170 applies an electric field to modulate the tunneling current at a bonding interface between substrate 110 and core nanowire 131. Further, when the polarity of the gate voltage is the other one of positive and negative, FET 100 according to the present embodiment operates as a first conductivity type field-effect transistor (FET) in which gate electrode 170 applies an electric field to modulate the heat-diffusion current in shell layer 134.

More specifically, when substrate 110 and shell layer 134 are of the p-type (first conductivity type) and core nanowire 131 is of the n-type (second conductivity type), FET 100 operates as an n-type TFET (nTFET) by setting the polarity of the gate voltage to positive (V_{G} > 0), and operates as a p-type FET (pFET) by setting the polarity of the gate voltage to negative (V_{G} < 0).

Further, when substrate 110 and shell layer 134 are of the n-type (first conductivity type) and core nanowire 131 is of the p-type (second conductivity type), FET 100 operates as a p-type TFET (pTFET) by setting the polarity of the gate voltage to negative (V_{G} < 0), and operates as an n-type FET (nFET) by setting the polarity of the gate voltage to positive (V_{G} > 0).

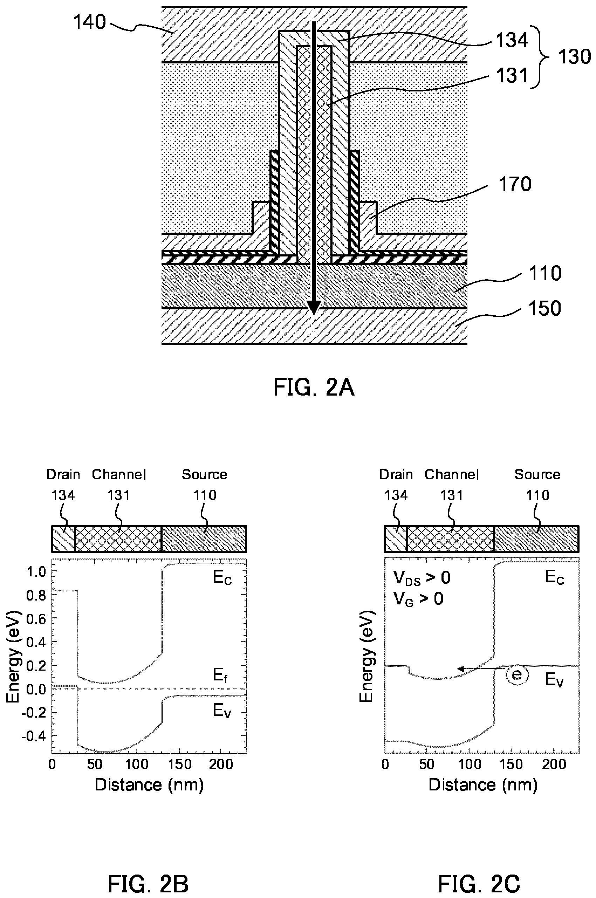

FIGS. 2A to 2C illustrate how FET 100 operates as an n-type TFET when substrate 110 and shell layer 134 are of the p-type (first conductivity type) and core nanowire 131 is of the n-type (second conductivity type). FIG. 2A is a cross-sectional schematic view of FET 100 illustrating the flow of current; FIG. 2B is a band diagram in a thermal equilibrium state; and FIG. 2C is a band diagram when the polarity of the drain-source voltage is positive (V_{DS} > 0) and the polarity of the gate voltage is positive (V_{G} > 0). The aspect ratio in FIG. 2A is changed from that in FIG. 1 to make the current flow easier to see in FIG. 2A.

As illustrated in FIGS. 2A to 2C, when a sufficient gate voltage with the drain-source voltage polarity being positive (V_{G} > 0) and the gate voltage polarity being positive (V_{DS} > 0) is applied, band-to-band tunneling occurs at the bonding interface between substrate 110 and core nanowire 131, and a current flows from first electrode 140 to second electrode 150. That is, FET 100 operates as an nTFET.

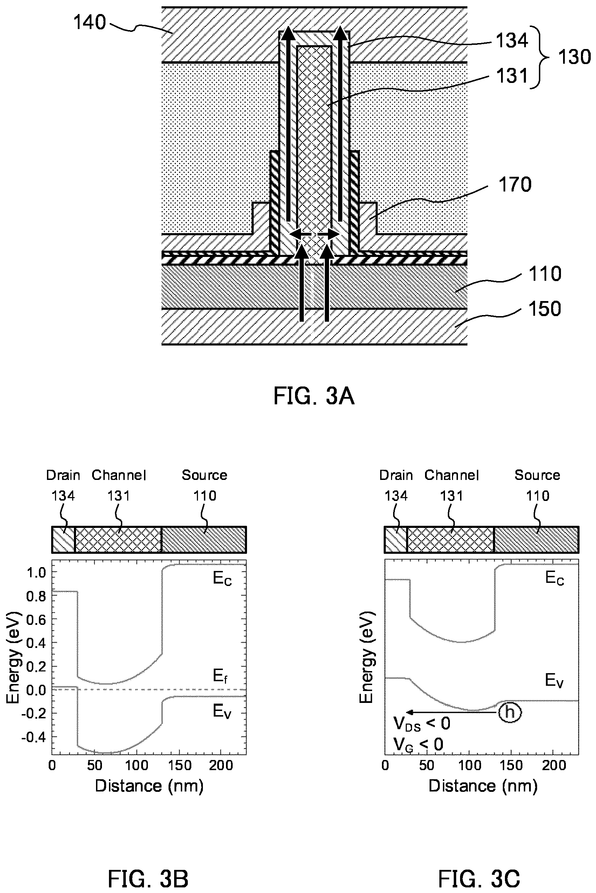

FIGS. 3A to 3C illustrate how FET 100 operates as a p-type FET (MOSFET) when substrate 110 and shell layer 134 are of the p-type (first conductivity type) and core nanowire 131 is of the n-type (second conductivity type). FIG. 3A is a cross-sectional schematic view of FET 100 illustrating the flow of current; FIG. 3B is a band diagram in a thermal equilibrium state; and FIG. 3C is a band diagram when the polarity of the drain-source voltage is negative (V_{DS} < 0) and the polarity of the gate voltage is negative (V_{G} < 0). The aspect ratio is changed from that in FIG. 1 to make the current flow easier to see in FIG. 3A.

As illustrated in FIGS. 3A to 3C, when a sufficient gate voltage with the drain-source voltage polarity being negative (V_{DS} < 0) and the gate voltage polarity being negative (V_{G} < 0), the valence band barrier in shell layer 134, which is in contact with core nanowire 131, becomes small, and a current flows from second electrode 150 to first electrode 140. That is, FET 100 operates as a pFET (pMOSFET).

As described above, FET 100 according to the present embodiment can be operated as an n-type field-effect transistor (nFET) or as a p-type field-effect transistor (pFET) by switching the polarity of the gate voltage. Accordingly, since the configurations of the nFET and the pFET are the same, it is possible to manufacture the nFET and the pFET simultaneously and easily.

By utilizing FET 100 according to the present embodiment as a switching element, it is possible to reduce the power consumption of a semiconductor device. As a result, energy saving and reduction in environmental load can be achieved.

### (Manufacturing Method of Field-Effect Transistor)

The manufacturing method is not claimed but it is useful for understanding the present invention.

The manufacturing method of FET 100 is not particularly limited. Many components of FET 100 (excluding shell layer 134) can be fabricated using, for example, the method described in PTL 1 (WO2011/040012).

For example, FET 100, in which substrate 110 and shell layer 134 are of the p-type (first conductivity type) and core nanowire 131 is of the n-type (second conductivity type), can be manufactured by the following procedure.

First, substrate 110 made of a Group IV semiconductor highly doped to a p-type dopant is prepared. Insulating film 120 is formed on the (111) surface of substrate 110 by a thermal oxidation method or the like. Subsequently, an opening having a predetermined size (for example, a diameter of 80 nm) is formed in insulating film 120 on substrate 110 using a photolithography method or the like.

Subsequently, core nanowires 131 made of a Group III-V compound semiconductor are grown from the exposed (111) surface of substrate 110 through the opening by a metal organic vapor phase epitaxy method (also referred to as the MOVPE method), a molecular beam epitaxy method (also referred to as the MBE method), or the like. At this time, it is preferable to form a Group III-V compound semiconductor thin film on the (111) surface of substrate 110 by the alternate material supply modulation method before growing core nanowire 131 (see PTL 1).

Core nanowire 131 is doped n-type. For example, by supplying a doping gas or a doping organic metal to core nanowire 131 while core nanowire 131 is formed by the MOVPE method, core nanowire 131 can be doped with an n-type dopant. At this time, first region 132 n-doped with a low concentration (low-doped) and second region 133 n-doped with a high concentration (high-doped) may be formed by changing the concentration of the doping gas or the doping organic metal during the process. Further, the low-doped first region 132 and the high-doped second region 133 of core nanowire 131 may be formed by respectively implanting ions made of Group IV atoms into a portion (to become first region 132) of core nanowire 131 and into a portion (to become second region 133) of core nanowire 131 by an ion implantation method.

Next, shell layer 134 is formed on the surface of core nanowire 131. Shell layer 134 is formed by, for example, the MOVPE method or the MBE method. From the viewpoint of reducing the number of work steps, the method for forming shell layer 134 is preferably the same as the method for producing core nanowire 131. For example, to form shell layer 134 made of GaSb on the surface of core nanowire 131 made of InGaAs, a source gas containing gallium and a source gas containing antimony may be supplied to grow GaSb (shell layer 134) at 580°C.

Shell layer 134 is doped to the same first conductivity type (p-type or n-type) as substrate 110. For example, by simultaneously supplying a gas or organometallic material containing Group VI atoms and the material for shell layer 134 using the MOVPE method, a p-type shell layer 134 can be formed. Similarly, by simultaneously supplying a gas or organic metal material containing Group IV atoms and the material for shell layer 134 using the MOVPE method, an n-type shell layer 134 can be formed. The types of doping gas and doping organic metal are not particularly limited as long as they include C, Zn, or Te for p-type doping, and C, Si, Ge, Sn, O, S, Se, or Te for n-type doping.

Thus, FET 100 according to the present embodiment can be manufactured by the above-described uclaimed procedure.

### (Effects)

As described above, field-effect transistor 100 according to Embodiment 1 can be operated as an n-type field-effect transistor (nFET) or as a p-type field-effect transistor (pFET) by switching the polarities of the gate voltage and the drain voltage. Accordingly, the present invention can manufacture an nFET and a pFET simultaneously and easily.

### [Embodiment 2]

### (Configuration of Field-Effect Transistor)

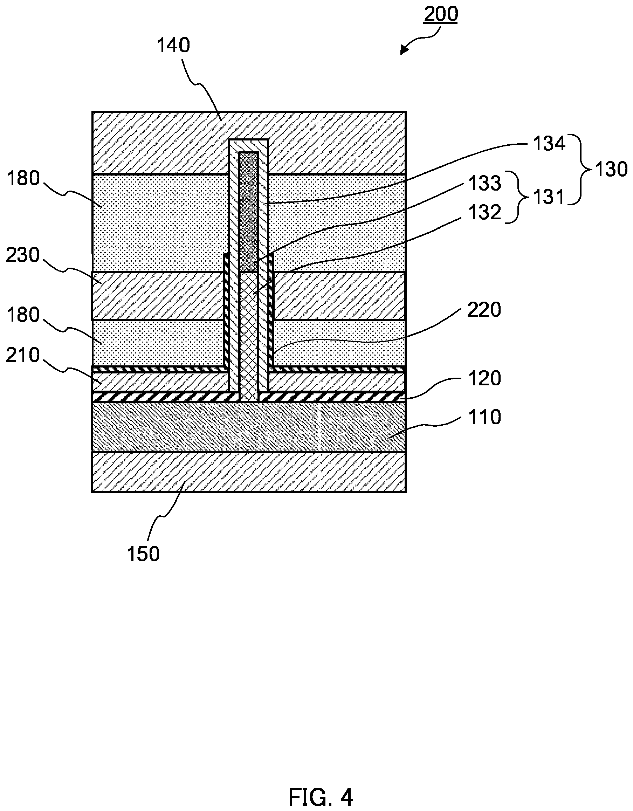

FIG. 4 is a cross-sectional schematic view illustrating the configuration of field-effect transistor (FET) 200 according to Embodiment 2 of the present invention. As illustrated in FIG. 4, FET 200 according to the present embodiment includes substrate 110, insulating film 120, core-shell nanowire 130, first electrode 140, second electrode 150, third electrode 210, gate dielectric film 220, gate electrode 230, and insulating protective film 180.

FET 200 according to the present embodiment differs from field-effect transistor 100 according to Embodiment 1 in that FET 200 includes third electrode 210. Hereinafter, the same components as those in field effect transistor 100 according to Embodiment 1 will be denoted by the same reference signs, and their description will be omitted.

Third electrode 210 is electrically connected to shell layer 134 of core-shell nanowire 130. In the present embodiment, third electrode 210 is disposed on insulating film 120. Third electrode 210 functions as one of a source electrode and a drain electrode for an FET of the first conductivity type, in which gate electrode 230 applies an electric field to modulate the heat-diffusion current in shell layer 134. Further, in the present embodiment, second electrode 150 functions as the one of the source electrode and drain electrode for the second conductivity type TFET, in which gate electrode 230 applies an electric field to modulate a tunneling current at the bonding interface. First electrode 140 functions as the other one of the source electrode and the drain electrode for both the second conductivity type TFET and the first conductivity type FET.

For example, first electrode 140 may function as a drain electrode for both a TFET of the second conductivity type and an FET of the first conductivity type, second electrode 150 may function as a source electrode for a TFET of the second conductivity type, and third electrode 210 may function as a source electrode for an FET of the first conductivity type. In this case, second electrode 150 and third electrode 210 may be grounded. Further, first electrode 140 may function as a source electrode for both a TFET of the second conductivity type and an FET of the first conductivity type, second electrode 150 may function as a drain electrode for a TFET of the second conductivity type, and third electrode 210 may function as a drain electrode for an FET of the first conductivity type. In this case, first electrode 140 may be grounded.

The type of third electrode 210 is not particularly limited, but a metal film, an alloy film, or a metal multilayer film capable of making ohmic contact with shell layer 134 is preferable. The examples of third electrode 210 are the same as the examples of first electrode 140.

Gate dielectric film 220 covers at least a part of the side surface of core-shell nanowire 130. In the present embodiment, gate dielectric film 220 covers third electrode 210 and the lower half of the side surface of core-shell nanowire 130. Other aspects of gate dielectric film 220 are the same as those of gate dielectric film 160 of FET 100 in Embodiment 1.

Gate electrode 230 is disposed on gate dielectric film 220 so as to cover at least a part of the periphery of core-shell nanowire 130. More specifically, gate electrode 230 is disposed on gate dielectric film 220 so as to apply an electric field to the bonding interface between substrate 110 and core nanowire 131 and to a region of shell layer 134 (the region between a connecting portion of shell layer 134 to first electrode 140 and a connecting portion of shell layer 134 to third electrode 210). Other aspects of gate electrode 230 are the same as those of gate electrode 170 of FET 100 in Embodiment 1.

### (Operation of Field-Effect Transistor)

In the same manner as FET 100 according to Embodiment 1, when the polarity of the gate voltage is one of positive and negative, FET 200 according to Embodiment 2 operates as a second conductivity type tunneling field-effect transistor (TFET) in which gate electrode 230 applies an electric field to modulate the tunneling current at a bonding interface between substrate 110 and core nanowire 131. Further, when the polarity of the gate voltage is the other one of positive and negative, FET 200 according to Embodiment 2 operates as a first conductivity type field-effect transistor (FET) in which gate electrode 230 applies an electric field to modulate the heat-diffusion current in shell layer 134.

More specifically, when substrate 110 and shell layer 134 are of the p-type (first conductivity type) and core nanowire 131 is of the n-type (second conductivity type), FET 200 operates as an n-type TFET (nTFET) by setting the polarity of the gate voltage to positive (V_{G} > 0), and operates as a p-type FET (pFET) by setting the polarity of the gate voltage to negative (V_{G} < 0). When FET 200 operates as an nTFET, a current flows between first electrode 140 and second electrode 150. When FET 200 operates as a pFET, on the other hand, a current flows between first electrode 140 and third electrode 210.

Further, when substrate 110 and shell layer 134 are of the n-type (first conductivity type) and core nanowire 131 is of the p-type (second conductivity type), FET 200 operates as a p-type TFET (pTFET) by setting the polarity of the gate voltage to negative (V_{G} < 0), and operates as an n-type FET (nFET) by setting the polarity of the gate voltage to positive (V_{G} > 0). When FET 200 operates as a pTFET, a current flows between first electrode 140 and second electrode 150. When FET 200 operates as an nFET, on the other hand, a current flows between first electrode 140 and third electrode 210.

### (Effects)

As described above, in FET 200 according to Embodiment 2, when FET 200 is operated as a FET of the first conductivity type, the current that flows between first electrode 140 (which functions as, for example, a drain electrode) and third electrode 210 (which functions as, for example, a source electrode) does not pass through the hetero interface between substrate 110 and core nanowire 131 or the hetero interface between core nanowire 131 and shell layer 134, but passes through only shell layer 134. Accordingly, FET 200 according to Embodiment 2 can increase the drain current when operated as the FET of the first conductivity type, in addition to providing the same effects as FET 100 according to Embodiment 1.

### Examples

Hereinafter, a device according to the invention and the unclaimed method useful for understanding the invention will be described in detail with reference to examples.

### 1. Manufacture of Field-Effect Transistor

A p-type silicon (111) substrate (carrier concentration: 7×10¹⁸ cm⁻³) was subjected to thermal oxidation treatment to form a silicon oxide film having a film thickness of 20 nm on the surface of the substrate. Openings were periodically formed in the silicon oxide film using electron beam lithography and wet chemical etching, exposing the surface of the silicon substrate. The shape of the opening was hexagonal, and the size of the opening (diameter of the circumscribed circle) was 80 nm.

A substrate with openings formed thereon was set in a low-pressure horizontal MOVPE apparatus (HR2339; Taiyo Nippon Sanso Corporation). The temperature of the silicon substrate was increased to 925°C and maintained for 5 minutes, thereby removing the natural oxide film formed on the surface of the openings on the silicon substrate. Subsequently, the temperature of the silicon substrate was decreased from 925°C to 400°C. Arsenic hydride was supplied together with hydrogen gas (carrier gas). The partial pressure of the arsenic hydride was set to 1.3×10⁻⁴ atm.

Next, a thin film of InGaAs was formed in the opening of the silicon substrate by the alternate material supply modulation method. Specifically, the combination of the supply of trimethylindium and trimethylgallium for 1 second, the interval with hydrogen gas for 2 seconds, the supply of arsenic hydride for 1 second, and the interval with hydrogen gas for 2 seconds was used as one cycle, and the cycle was repeated 20 times over 2 minutes. The partial pressure of trimethylindium was 4.7×10⁻⁷ atm, the partial pressure of trimethylgallium was 5.7×10⁻⁷ atm, and the partial pressure of arsenic hydride was 1.3×10⁻⁴ atm.

Next, after increasing the temperature of the silicon substrate, an n-type In_{0.7}Ga_{0.3}As nanowire (core nanowire) having a thickness (diameter of the circumscribed circle) of 80 nm and a length of 1.2 µm was grown by the MOVPE method. Specifically, after increasing the temperature of the silicon substrate from 400°C to 670°C, trimethylindium, trimethylgallium, arsenic hydride, and monosilane were supplied together with hydrogen gas to grow a 100 nm-long n-type In_{0.7}Ga_{0.3}As nanowire (first region). The partial pressure of trimethylindium was 5.0×10⁻⁷ atm, the partial pressure of trimethylgallium was 1.0×10⁻⁶ atm, the partial pressure of arsenic hydride was 2.5×10⁻⁴ atm, and the partial pressure of monosilane was 1.3×10⁻⁷ atm. The concentration of the dopant (Si) in the first region was 5×10¹⁸ cm⁻³. Subsequently, trimethylindium, trimethylgallium, arsenic hydride, and monosilane were supplied together with hydrogen gas to grow an n-type In_{0.7}Ga_{0.3}As nanowire (second region) having a length of 1.1 µm. The partial pressure of trimethylindium was 4.9×10⁻⁷ atm, the partial pressure of trimethylgallium was 5.7×10⁻⁷ atm, the partial pressure of arsenic hydride was 1.3×10⁻⁴ atm, and the partial pressure of monosilane was 7.0×10⁻⁸ atm. The concentration of the dopant (Si) in the second region was 5×10¹⁸ cm⁻³.

Next, a p-type GaSb layer (shell layer) was formed around an In_{0.7}Ga_{0.3}As nanowire (core nanowire). Specifically, the temperature of the silicon substrate was set to 580°C, and trimethylgallium, trimethylaminoantimony, and dimethylzinc were supplied together with hydrogen gas to form a GaSb layer (shell layer) having a film thickness of 45 nm on the side surface of the In_{0.7}Ga_{0.3}As nanowire (core nanowire). The partial pressure of trimethylgallium was 1.0×10⁻⁶ atm, the partial pressure of trimethylaminoantimony was 5.0×10⁻⁵ atm, and the partial pressure of dimethylzinc was 4.0×10⁻⁷ atm. The concentration of the dopant (Zn) in the GaSb layer (shell layer) was 1×10¹⁹ cm⁻³.

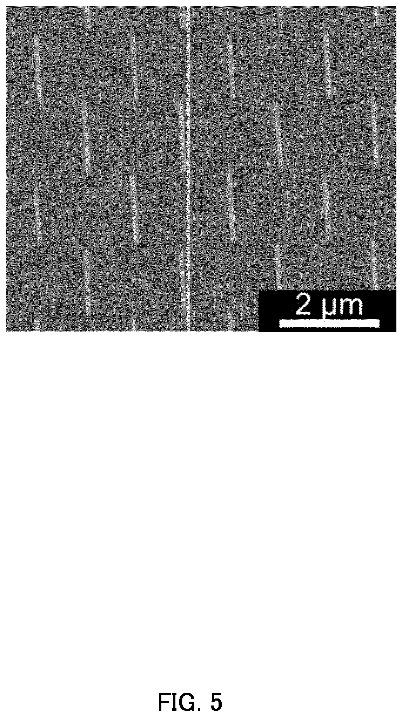

By these steps, core-shell nanowires each having a thickness (diameter of the circumscribed circle) of 170 nm and a length of 1.2 µm were formed on the silicon substrate surface. FIG. 5 is a scanning electron microscope photograph (perspective view) of a silicon substrate with periodically arranged core-shell nanowires. As illustrated in FIG. 5, the long axis of the core-shell nanowire was perpendicular to the surface of the silicon substrate.

A gate dielectric film was formed on the side surface of a core-shell nanowire, and further, a gate electrode was formed on the gate dielectric film. Specifically, a Hf_{0.8}Al_{0.2}O film (gate dielectric film) having a film thickness of 10 nm was formed by the ALD method. Subsequently, a W film (gate electrode) having a thickness of 100 nm was formed on a portion of the core-shell nanowire (the portion on the silicon substrate side) by using a highfrequency sputtering method. The length of the gate electrode along the long axis direction of the core-shell nanowire was 200 nm.

Next, an insulating resin (BCB resin) film was formed on the silicon substrate, embedding the core-shell nanowires and the like on the silicon substrate in the insulating resin. Subsequently, the upper portion of the insulating resin was removed by reactive ion etching to expose the tips of the core-shell nanowires.

Next, a Ti (20 nm)/Pd (20 nm)/Au (100 nm) multilayer film having a total thickness of 120 nm was formed as the first electrode (drain electrode) on the surface where the core-shell nanowires were exposed. Further, a Ti (20 nm)/Au (30 nm) multilayer film having a film thickness of 50 nm was formed on the silicon substrate as the second electrode (source electrode).

Thus, an FET according to Embodiment 1 of the present invention was manufactured (see FIG. 1) by the above-described unclaimed procedure.

### 2. Evaluation of Electrical Characteristics

The electrical characteristics of the FET produced in the above steps were measured.

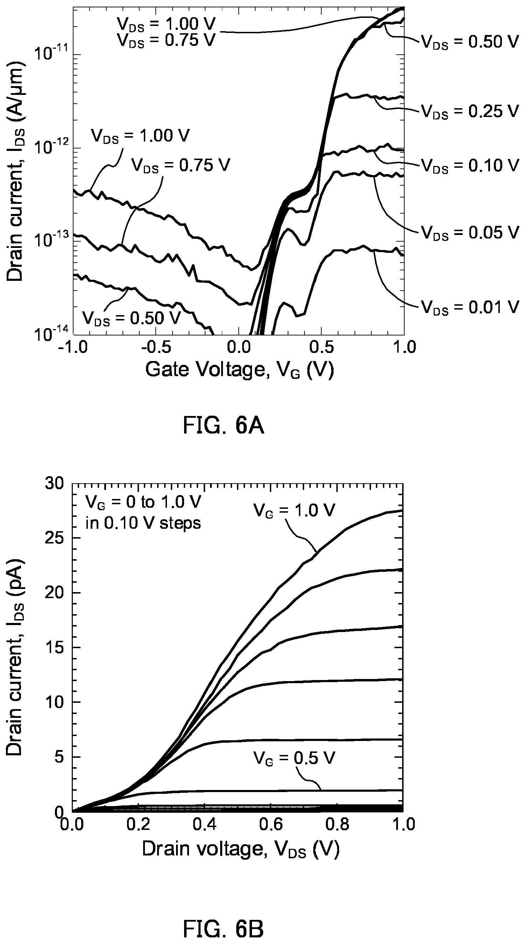

FIG. 6A is a graph illustrating the relationship (transfer characteristic) between the gate voltage (V_{G}) and the drain current (I_{DS}) when the FET operates as an nTFET (V_{DS} = 0.01 V, 0.05 V, 0.10 V, 0.25 V, 0.50 V, 0.75 V, 1.00 V). FIG. 6B is a graph illustrating the relationship (output characteristics) between the drain voltage (V_{DS}) and the drain current (I_{DS}) when the FET operates as an nTFET (V_{G} = 0 V to 1.0 V, in 0.10 V steps).

As illustrated in FIGS. 6A and 6B, when the polarity of the drain-source voltage was positive (V_{DS} > 0) and the polarity of the gate voltage was positive (V_{G} > 0), the drain current was modulated by the gate bias. This indicates that the FET operates as an nFET. The ON/OFF ratio was up to 10³, and the minimum sub-threshold coefficient was 105 mV/decade.

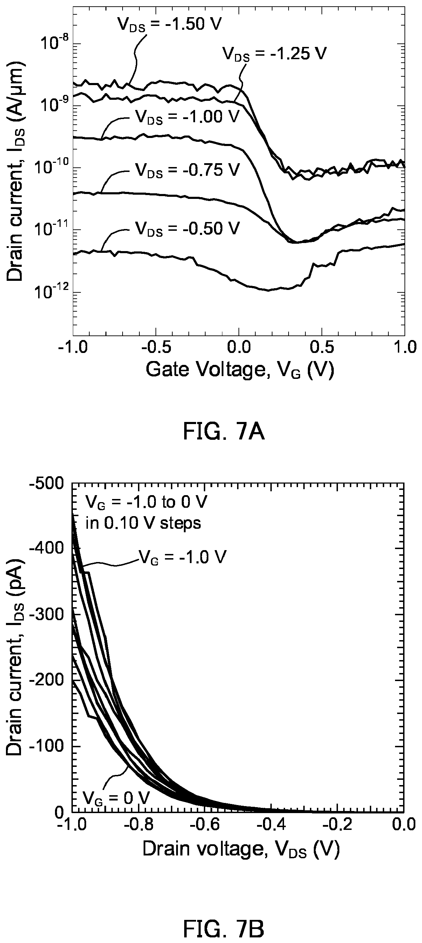

FIG. 7Ais a graph illustrating the relationship (transfer characteristics) between the gate voltage (V_{G}) and the drain current (I_{DS}) when the FET operates as a pFET (V_{DS}= -1.50 V, -1.25 V, -1.00 V, -0.75 V, -0.50 V). FIG. 7B is a graph illustrating the relationship (output characteristics) between the drain voltage (V_{DS}) and the drain current (I_{DS}) when the FET operates as a pFET (V_{G} = -1.0 V to 0 V, in 0.10 V steps).

As illustrated in FIGS. 7A and 7B, when the polarity of the drain-source voltage was negative (V_{DS} < 0) and the polarity of the gate voltage was negative (V_{G} < 0), the drain current was modulated by the gate bias. This indicates that the FET operates as a pFET. The ON/OFF ratio was up to 10², and the minimum subthreshold coefficient was 115 mV/decade.

This application claims priority based on Japanese Patent Application No. 2022-048567, filed on March 24, 2022.

### Industrial Applicability

The FET according to the present invention is useful, for example, as a switching element formed in a semiconductor microprocessor and a high-density integrated circuit.

### Reference Signs List

100, 200 Field-effect transistor
110 Substrate
120 Insulating film
130 Core-shell nanowire
131 Core nanowire
132 First region
133 Second region
134 Shell layer
140 First electrode
150 Second electrode
160, 220 Gate dielectric film
170, 230 Gate electrode
180 Insulating protective film
210 Third electrode

## Claims

1. A field-effect transistor (100, 200), comprising:
a substrate (110) that has a (111) surface and is made of a Group IV semiconductor doped to a first conductivity type;
an insulating film (120) covering the (111) surface of the substrate (110), the insulating film (120) comprising an opening;
a core-shell nanowire (130) that includes a core nanowire (131) and a shell layer (134), wherein the core nanowire (131) is connected to the (111) surface exposed in the opening and is made of a Group III-V compound semiconductor, and the shell layer (134) is disposed on the insulating film (120) around the opening to cover the core nanowire (131) and is made of a Group III-V compound semiconductor;
a first electrode (140) that is electrically connected to the shell layer (134);
a second electrode (150) that is electrically connected to the substrate (110); and
a gate electrode (170, 230),
wherein
the core nanowire (131) is doped to a second conductivity type different from the first conductivity type,
the shell layer (134) covers a side surface of the core nanowire (131) and an end surface of the core nanowire (131) on the first electrode (140) side, but does not cover an end surface of core nanowire (131) on the substrate (110) side, and the shell layer (134) is doped to the first conductivity type,
the gate electrode (170, 230) is configured to apply an electric field to an interface between the substrate (110) and the core nanowire (131) and to the shell layer (134).

2. The field-effect transistor (100, 200) according to claim 1, wherein:
the core nanowire (131) includes a first region (132) and a second region (133), the first region (132) being connected to the (111) surface; and
an impurity density in the first region (132) is different from an impurity density in the second region (133).

3. The field-effect transistor (100, 200) according to claim 1 or 2, further comprising:
a gate dielectric film (160, 220) disposed on a side surface of the core-shell nanowire (130),
wherein
the gate electrode (170, 230) is disposed on the gate dielectric film (160, 220).

4. The field-effect transistor (200) according to any one of claims 1 to 3, further comprising:
a third electrode (210) electrically connected to the shell layer (134),
wherein
the gate electrode (230) is disposed so as to apply the electric field to the interface between the substrate (110) and the core nanowire (131) and to a region of the shell layer (134), the region being located between a connecting portion of the shell layer (134) to the first electrode (140) and a connecting portion of the shell layer (134) to the third electrode (210).

5. A switching element, comprising:
the field-effect transistor (100, 200) according to any one of claims 1 to 4.

## Patentansprüche

1. Feldeffekttransistor (100, 200), umfassend:
ein Substrat (110) mit einer (111) Oberfläche und hergestellt aus einem zu einem ersten Leitertyp dotierten Gruppe-IV-Halbleiter;
einen die (111) Oberfläche des Substrats (110) bedeckenden isolierenden Film (120), wobei der isolierende Film (120) eine Öffnung umfasst;
einen einen Kern-Nanodraht (131) und eine Mantellage (134) aufweisenden Kern-Mantel-Nanodraht (130), wobei der Kern-Nanodraht (131) mit der in der Öffnung freiliegenden (111) Oberfläche verbunden ist und aus einem Gruppe-III-V-Verbund-Halbleiter hergestellt ist, und die Mantellage (134) auf dem isolierenden Film (120) um die Öffnung herum angeordnet ist, um den Kern-Nanodraht (131) zu bedecken, und aus einem Gruppe-III-V-Verbund-Halbleiter hergestellt ist;
eine mit der Mantellage (134) elektrisch verbundene erste Elektrode (140);
eine mit dem Substrat (110) elektrisch verbundene zweite Elektrode (150);
eine Gate-Elektrode (170, 230);
wobei
der Kern-Nanodraht (131) zu einem von dem ersten Leitertyp sich unterscheidenden zweiten Leitertyp dotiert ist,
die Mantellage (134) eine Seitenfläche des Kern-Nanodraht (131) und eine Stirnfläche des Kern-Nanodrahts (131) an der Seite der ersten Elektrode (134) bedeckt, jedoch eine Stirnfläche des Kern-Nanodrahts (131) an der Seite des Substrats (110) nicht bedeckt, und die Mantellage (134) zu dem ersten Leitertyp dotiert ist,
die Gate-Elektrode (170, 230) zum Anlegen eines elektrischen Feldes an einen Übergang zwischen dem Substrat (110) und dem Kern-Nanodraht (131) und an die Mantellage (134) konfiguriert ist.

2. Feldeffekttransistor (100, 200) nach Anspruch 1, wobei:
der Kern-Nanodraht (131) einen ersten Bereich (132) und einen zweiten Bereich (133) aufweist, wobei der erste Bereich (132) mit der (111) Oberfläche verbunden ist; und
eine Verunreinigungsdichte in dem ersten Bereich (132) sich von einer Verunreinigungsdichte in dem zweiten Bereich (133) unterscheidet.

3. Feldeffekttransistor (100, 200) nach Anspruch 1 oder 2, ferner umfassend:
einen an einer Seitenfläche des Kern-Nanodrahts (130) angeordneten dieelektrischen Gate-Film (160, 220),
wobei
die Gate-Elektrode (170, 230) auf dem dielektrischen Gate-Film (160, 220) angeordnet ist.

4. Feldeffekttransistor (100, 200) nach einem der Ansprüche 1-3, ferner umfassend:
eine mit der Mantellage (134) elektrisch verbundene dritte Elektrode (210),
wobei
die Gate-Elektrode (230) zum Anlegen des elektrischen Feldes an den Übergang zwischen dem Substrat (110) und dem Kern-Nanodraht (131) und an einen Bereich der Mantellage (134) angeordnet ist, wobei der Bereich zwischen einem Verbindungsabschnitt der Mantellage (134) mit der ersten Elektrode (140) und einem Verbindungsabschnitt der Mantellage (134) mit der dritten Elektrode (210) positioniert ist.

5. Schaltelement, umfassend:
den Feldeffekttransistor (100, 200) nach einem der Ansprüche 1-4.

## Revendications

1. Transistor à effet de champ (100, 200), comprenant :
un substrat (110) qui a une surface (111) et est constitué d'un semi-conducteur du groupe IV dopé à un premier type de conductivité ;
un film isolant (120) recouvrant la surface (111) du substrat (110), le film isolant (120) comprenant une ouverture ;
un nanofil cœur/coquille (130) qui comprend un nanofil cœur (131) et une couche coquille (134), dans lequel le nanofil cœur (131) est connecté à la surface (111) exposée dans l'ouverture et est composé d'un semi-conducteur à composés des groupes III-V, et la couche coquille (134) est disposée sur le film isolant (120) autour de l'ouverture pour recouvrir le nanofil cœur (131) et est constituée d'un semi-conducteur à composés des groupes III-V ;
une première électrode (140) qui est connectée électriquement à la couche coquille (134) ;
une deuxième électrode (150) qui est connectée électriquement au substrat (110) ; et
une électrode de grille (170, 230),
dans lequel
le nanofil cœur (131) est dopé à un deuxième type de conductivité différent du premier type de conductivité,
la couche coquille (134) recouvre une surface latérale du nanofil cœur (131) et une surface d'extrémité du nanofil cœur (131) sur le côté de la première électrode (140), mais ne recouvre pas une surface d'extrémité du nanofil cœur (131) sur le côté du substrat (110), et la couche coquille (134) est dopée au premier type de conductivité,
l'électrode de grille (170, 230) est configurée pour appliquer un champ électrique à une interface entre le substrat (110) et le nanofil cœur (131) et à la couche coquille (134).

2. Transistor à effet de champ (100, 200) selon la revendication 1, dans lequel :
le nanofil cœur (131) comporte une première région (132) et une deuxième région (133), la première région (132) étant connectée à la surface (111) ; et
une densité d'impuretés dans la première région (132) est différente d'une densité d'impuretés dans la deuxième région (133).

3. Transistor à effet de champ (100, 200) selon la revendication 1 ou 2, comprenant en outre :
un film diélectrique de grille (160, 220) disposé sur une surface de côté du nanofil cœur/coquille (130),
dans lequel
l'électrode de grille (170, 230) est disposée sur le film diélectrique de grille (160, 220).

4. Transistor à effet de champ (200) selon l'une quelconque des revendications 1 à 3, comprenant en outre :
une troisième électrode (210) connectée électriquement à la couche coquille (134),
dans lequel
l'électrode de grille (230) est disposée de manière à appliquer le champ électrique à l'interface entre le substrat (110) et le nanofil cœur (131) et à une région de la couche coquille (134), la région étant située entre une portion de connexion de la couche coquille (134) à la première électrode (140) et une portion de connexion de la couche coquille (134) à la troisième électrode (210).

5. Élément de commutation, comprenant :
le transistor à effet de champ (100, 200) selon l'une quelconque des revendications 1 à 4.
